# FASCICULE DE BREVET EUROPEEN

(11) **EP 2 816 679 B1**
(45) Date de publication et mention de la délivrance du brevet: **21.09.2022**
(21) Numéro de dépôt: 13305845.3
(22) Date de dépôt: 21.06.2013
(51) Int. Cl.: H01S 5/026, H01S 5/0625, H01S 5/10, H01S 5/22

(54) **Dispositif d'émission laser à modulateur de lumière intégré**
Laseremissionsvorrichtung mit integriertem Lichtmodulator
Laser-emission device with built-in light modulator

(43) Date de publication de la demande: 24.12.2014
(73) Titulaire: Alcatel Lucent, 91620 Nozay (FR); COMMISSARIAT À L'ÉNERGIE ATOMIQUE ET AUX ÉNERGIES ALTERNATIVES, 75015 Paris (FR)
(72) Inventeur: Accard, Alain, 91767 Palaiseau (FR); Mallecot, Franck, 91767 Palaiseau (FR); Blache, Fabrice, 91767 Palaiseau (FR)
(74) Mandataire: Loyer & Abello

(56) Documents cités:
- EP-A1- 2 544 319
- WO-A2-02/058251
- US-A1- 2009 245 298
- SIDDHARTH R. JAIN ET AL: "Integrated hybrid silicon DFB laser-EAM array using quantum well intermixing", OPTICS EXPRESS, vol. 19, no. 14, 4 juillet 2011 (2011-07-04), page 13692, XP055086821, ISSN: 1094-4087, DOI: 10.1364/OE.19.013692
- JAIN S R ET AL: "Integrated Hybrid Silicon Transmitters", JOURNAL OF LIGHTWAVE TECHNOLOGY, IEEE SERVICE CENTER, NEW YORK, NY, US, vol. 30, no. 5, 1 mars 2012 (2012-03-01), pages 671-678, XP011405622, ISSN: 0733-8724, DOI: 10.1109/JLT.2011.2174028
- HYUNDAI PARK ET AL: "Device and Integration Technology for Silicon Photonic Transmitters", IEEE JOURNAL OF SELECTED TOPICS IN QUANTUM ELECTRONICS, IEEE SERVICE CENTER, PISCATAWAY, NJ, US, vol. 17, no. 3, 1 mai 2011 (2011-05-01), pages 671-688, XP011326478, ISSN: 1077-260X, DOI: 10.1109/JSTQE.2011.2106112
- DEKUN LIU ET AL: "Rate Equation Analysis of High Speed Q-Modulated Semiconductor Laser", JOURNAL OF LIGHTWAVE TECHNOLOGY, IEEE SERVICE CENTER, NEW YORK, NY, US, vol. 28, no. 21, 1 novembre 2010 (2010-11-01), pages 3128-3135, XP011339918, ISSN: 0733-8724, DOI: 10.1109/JLT.2010.2077671

## Description

### Domaine technique

L'invention se rapporte au domaine des dispositifs d'émission laser à semi-conducteurs modulables, notamment à une source laser utilisable dans les communications optiques et en particulier dans un réseau optique à multiplexage de longueurs d'onde (ou WDM pour l'anglais Wavelength Division Multiplexing).

### Arrière-plan technologique

Un modulateur à électro absorption couplé à une source laser existe avec l'utilisation d'un Té de polarisation permettant d'associer au signal radiofréquence une composante continue. Le Té de polarisation présente un encombrement important qui est rédhibitoire pour la réalisation d'un composant compact. En outre, cette solution nécessite l'utilisation d'une résistance d'adaptation d'une valeur de 50 ohms aux bornes du modulateur à électro absorption. Cette résistance produit une dissipation thermique de 300 mW.

L'article "Integrated hybrid silicon DFB laser-EAM array using quantum well intermixing",OPTICS EXPRESS, vol. 19, no. 14, 4 juillet 2011, page 13692, XP055086821, décrit un laser évanescent hybride à semi-conducteur III-V sur silicium intégrant une section amplificatrice, une section modulateur électro-absorbant et une section de transition entre la section amplificatrice et la section modulateur. Ce laser présente une arête peu profonde dans les sections d'amplification et de modulation et une arête profonde dans la section de transition.

### Résumé

Une idée à la base de l'invention est de fournir un dispositif laser incluant un modulateur à électro absorption de faible encombrement. Une autre idée à la base de l'invention est de fournir un tel dispositif à dissipation thermique réduite.

Selon un mode de réalisation, l'invention fournit un dispositif d'émission laser à modulateur de lumière intégré comportant :
un guide d'onde multicouche, le guide d'onde s'étendant selon une direction longitudinale du dispositif,
le guide d'onde comprenant sur une couche de support réalisée en dioxyde de silicium,
une première couche guidante de silicium,
une première couche dopée,
une deuxième couche guidante en matériau amplificateur de lumière, et une seconde couche dopée de polarisation opposée à la première couche dopée,
   le guide d'onde comportant le long de la direction longitudinale
une section d'amplification laser,
une section de modulation de la lumière comportant une zone d'extraction pour rayonner la lumière d'un mode optique résonnant vers l'extérieur du dispositif, et une section de transition intercalée dans le sens longitudinal, entre la section d'amplification laser et la section de modulation de la lumière,
le dispositif comprenant en outre :
   une première électrode positive couplée à la section d'amplification laser pour injecter un courant de pompage dans la section d'amplification laser,
   une deuxième électrode positive couplée à la section de modulation de lumière pour injecter un signal de modulation dans la section de modulation,
   une troisième électrode négative couplée à la première couche dopée dans la section de modulation pour appliquer un potentiel électrique de polarisation à la première couche dopée,
   et une quatrième électrode de référence couplée à la première couche dopée dans la section d'amplification laser,
dans lequel la première couche dopée forme un canal résistif dans la section de transition entre la première couche dopé de la section d'amplification et la première couche dopé de la section de modulation, et dans lequel la seconde couche dopée comprend une isolation électrique située dans la section de transition du guide d'onde.

Selon des modes de réalisation, un tel dispositif d'émission laser à modulateur de lumière intégré peut comporter une ou plusieurs des caractéristiques suivantes.

Selon un mode de réalisation, l'isolation électrique est obtenue par une zone d'insertion protonée de la seconde couche dopée.

Grâce à ces caractéristiques, le dispositif reste compact.

Selon un mode de réalisation, le canal résistif présente une résistance comprise entre 1 et 10 kΩ, ce qui rend possible de régler de manière indépendante la polarisation du laser et la polarisation du modulateur.

Grâce à ces caractéristiques, la puissance dissipée est limitée, jusqu'à atteindre un niveau négligeable.

Selon un mode de réalisation, la seconde couche dopée et la première électrode positive forment une nervure étroite disposée sur la deuxième couche guidante, la nervure étroite ayant une largeur environ 5 fois inférieure à celle de la deuxième couche guidante dans une partie de la section d'amplification.

Selon un mode de réalisation, la largeur de la deuxième couche guidante dans une partie de la section d'amplification et une partie de la section de modulation, appelées zones de pleine largeur, est environ 5 fois supérieure à la largeur appelée zone étroite de ladite deuxième couche guidante dans la section de transition.

Selon un mode de réalisation, la largeur de la deuxième couche guidante se réduit progressivement depuis la largeur de chaque zone de pleine largeur vers la largeur de la zone étroite.

Grâce à ces caractéristiques, la propagation optique du mode entre la section d'amplification et la section de modulation n'est pas perturbée.

Selon un mode de réalisation, un profil en largeur de la première couche guidante est identique à un profil en largeur de la deuxième couche guidante.

Grâce à ces caractéristiques, la propagation optique du mode dans le guide d'onde n'est pas perturbée.

Selon un mode de réalisation, la première couche guidante, la première couche dopée, la deuxième couche guidante, la seconde couche dopée et la première électrode positive forment une nervure étroite dans la section de transition.

Grâce à ces caractéristiques, la section de transition forme un canal résistif de faible encombrement.

Selon un mode de réalisation, le canal résistif présente une largeur inférieure à 3 µm.

Selon un mode de réalisation, la zone de transition présente une longueur sensiblement égale à 50 µm.

Selon un mode de réalisation, la seconde couche dopée et la troisième couche dopée sont sélectionnées dans des matériaux du groupe III-V des semi-conducteurs.

Grâce à ces caractéristiques, le dispositif est réalisable selon une configuration collée sur du silicium sur isolant.

Selon un mode de réalisation, la seconde couche dopée présente une épaisseur inférieure à 250 nm.

Grâce à ces caractéristiques, la réalisation d'une structure composée de matériaux du groupe III-V collée sur du silicium sur isolant est possible sans perturber le mode optique.

Selon un mode de réalisation, la première électrode positive et la seconde couche dopée sont séparées par une couche d'un alliage d'arséniure de gallium indium dopé positivement.

Selon un mode de réalisation, la deuxième électrode positive et la seconde couche passive de ladite section de modulation sont séparées par une couche d'un alliage d'arséniure de gallium indium dopé positivement.

Selon un mode de réalisation, la troisième électrode négative est connectée à un potentiel continu négatif, la première électrode positive est connectée à un potentiel continu positif, l'électrode de référence est connectée à un potentiel électrique de terre, et la deuxième électrode positive est connectée à un générateur de signal en bande de base.

### Brève description des figures

L'invention sera mieux comprise, et d'autres buts, détails, caractéristiques et avantages de celle-ci apparaîtront plus clairement au cours de la description suivante d'un mode de réalisation particulier de l'invention, donné uniquement à titre illustratif et non limitatif, en référence aux dessins annexés.
- La figure 1 est une vue en coupe longitudinale de la tranche d'un dispositif laser.
- La figure 2 est une vue de dessus du dispositif de la figure 1.
- La figure 3 est une vue en coupe du dispositif de la figure 1, selon la coupe III-III.
- La figure 4 est la vue d'une section du dispositif de la figure 1, selon la section IV-IV.
- La figure 5 est une représentation schématique fonctionnelle du dispositif de la figure 1.

### Description détaillée de modes de réalisation

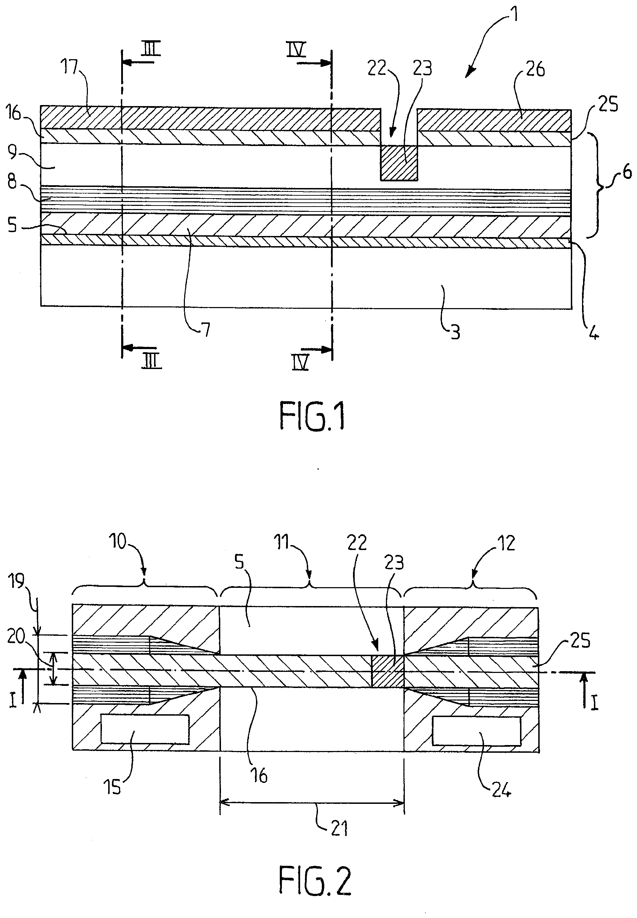

En référence aux **figures 1 à 4****,** on décrit maintenant une source laser à semi-conducteur 1 représentée dans différentes vues, notamment des vues en coupes. Les figures 1 et 2 représentent le dispositif, avec un grossissement longitudinal effectué sur la section de transition. Par convention, on appelle direction verticale, la direction perpendiculaire à la stratification des couches se succédant dans la tranche d'une vue en coupe ou d'une section du composant.

En partant du bas des figures, selon la direction verticale, la source laser comporte un premier composant optique en semi-conducteur 2, réalisé en silicium sur isolant (ou SOI pour l'anglais Silicon On Insulator). Ce premier composant optique est constitué d'une couche de base 3 en dioxyde de silicium SiO2, et une couche guidante 4, en silicium. Les interfaces entre couches sont planes et parallèles. La couche guidante 4 est recouverte d'une fine couche de dioxyde de silicium, non représentée.

Sur la surface supérieure 5 du composant 2 est disposé par collage, une structure multicouche, en semi-conducteur 6, réalisée par un exemple en matériaux du groupe III-V. Cette structure multicouche comporte une première couche dopée 7 négativement, une couche active 8, deux couches dopées positivement 9 et 16. Les couches dopées 7 et 9 sont dopées différemment, avec une polarisation opposée afin de permettre l'application d'un potentiel électrique entre les deux couches. L'ensemble ainsi obtenu forme une jonction P-N. Ainsi, la couche dopée 7 est dopée négativement, tandis que la couche dopée 8 est dopée positivement.

L'ensemble de couches ainsi assemblées constituent un guide d'onde formant une nervure orientée selon un axe longitudinal, qui correspond à l'axe I-I de la coupe de la figure 1, représenté sur la figure 2.

Selon l'axe longitudinal, le dispositif comprend une section d'amplification 10 suivie d'une section de transition 11, puis d'une section de modulation 12.

Le guide d'onde dans la section d'amplification 10 contient un moyen d'amplification correspondant à la couche active 8. Ce moyen d'amplification est obtenu à l'aide d'un matériau à puits quantique. Cette section produit une émission stimulée de lumière qui se propage au travers de la section de transition 11, jusqu'à la section de modulation 12. La section d'amplification 10 est alimentée à l'aide de deux électrodes, permettant d'appliquer un signal électrique à la jonction P-N. Une première électrode positive 17 est réalisée à l'aide d'une métallisation sur une partie de la couche dopée 9. Cette électrode positive 17 débute dans la section d'amplification 10 et se prolonge dans une partie de la section de transition 11. Cette électrode positive 17 laisse une portion non métallisée 22 de la couche dopée 9. Une électrode de référence 15 est réalisée également par métallisation, sur une portion de la couche dopée 7. Pour améliorer la polarisation, une couche fortement dopée 16 positivement est prise en sandwich entre la couche dopée 9 positivement et l'électrode 17.

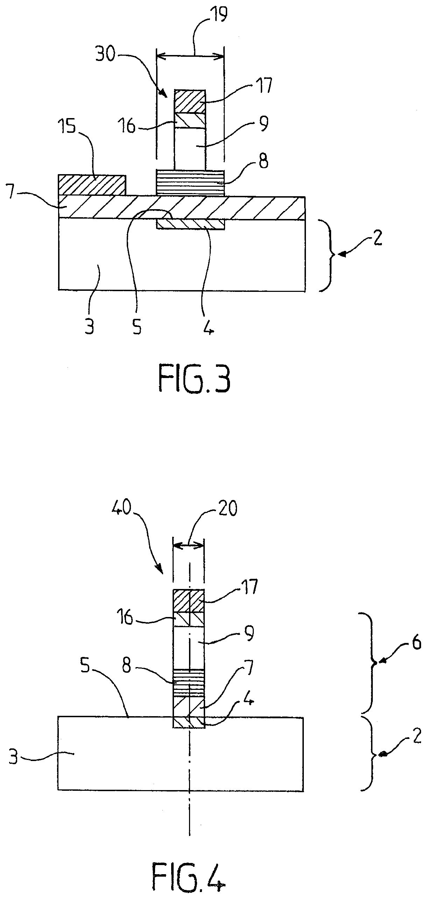

Les figures 2 et 3 montrent en outre que la largeur des différentes couches en matériau III-V constituant la nervure varie, dans la section d'amplification. La largeur 19 de la couche active 8 est par exemple cinq fois plus élevée que la largeur 20 des couches supérieures, les couches dopées 9 et 16 et l'électrode positive 17. Ce profil de nervure 30 est connu sous la terminologie anglaise de structure « shallow-ridge » ou nervure peu profonde. Dans la zone d'interface entre la section d'amplification 10 et la section de transition 11, la largeur de la couche active 8 diminue par un biseau pour former une couche active 8 de la largeur 20 des couches supérieures dans la section de transition 11.

Dans la section de transition, comme le présente la figure 4, le guide d'onde forme une nervure profonde 40 connue sous la terminologie anglaise de structure « deep-ridge ». Cette nervure profonde 40 est étroite. Elle comprend à une extrémité, à l'interface avec la section de modulation, la portion non métallisée 22. Dans cette portion non métallisée 22, la couche dopée 9 est isolée dans la profondeur 23. Cette isolation 23 est constituée par une zone chargée en protons. Cette charge est obtenue par un bombardement d'hydrogène à forte énergie qui pénètre la couche dopée 9.

La longueur 21 de la section de transition est relativement élevée par rapport à la largeur 20 de la nervure 40. La résistance d'un canal N ainsi constitué est le produit de la résistance au carré de cette couche, multiplié par la longueur 21 du canal, divisé par sa largeur 20.

À la seconde extrémité de la section de transition, à l'interface de la zone isolée 23 et de la section de modulation 12, la couche active 8 recouvre une largeur similaire à sa largeur 19 dans la section d'amplification 10. La nervure ainsi formée dans la section de modulation 12 est appelée par la terminologie anglaise, structure « shallow-ridge », tout comme pour la section d'amplification 10.

Le modulateur comprend en outre deux électrodes. Ces électrodes permettent la polarisation et donc la commande du modulateur. Elles servent à appliquer un champ électrique selon une direction perpendiculaire au faisceau lumineux modulé. Une électrode négative 24 est couplée à la couche dopée 7, pour appliquer un potentiel électrique de polarisation à la couche dopée 7. Par exemple, une alimentation continue de -4V est appliquée à cette électrode négative 24. Une électrode positive 26 est couplée par l'intermédiaire d'une couche fortement dopée positivement 25, à la partie de la couche dopée 9 située dans la section de modulation 12. L'électrode positive 26 permet d'injecter un signal de modulation.

Dans l'ensemble du dispositif, le profil de largeur de la couche guidante 4 est identique à celui de la couche active 8. En outre, le changement de structure entre les trois sections du composant optique et donc le passage d'une structure « shallow-ridge » à une structure « deep-ridge » puis de nouveau à une structure « shallow-ridge » ne perturbe pas la propagation optique du mode dans le composant.

Un tel composant peut par exemple être obtenu à l'aide d'une couche dopée 7 réalisée en phosphure d'indium (InP). La couche active 8 est obtenue à l'aide d'un matériau à puits quantique, par exemple une structure composée de 6 puits et barrières InGaAsP émettant à une longueur d'onde de 1,55 µm. La couche dopée 9 est par exemple réalisée en phosphure d'indium (InP). Les couches 16 et 25 sont réalisées à l'aide d'un alliage d'arséniure d'indium gallium (InGaAs). Les électrodes 15, 17, 24 et 26 sont réalisées dans un matériau à faible résistance électrique. Le matériau utilisé peut en outre avoir une forte résistance à l'oxydation. Par exemple, les électrodes sont réalisées avec de l'or (Au).

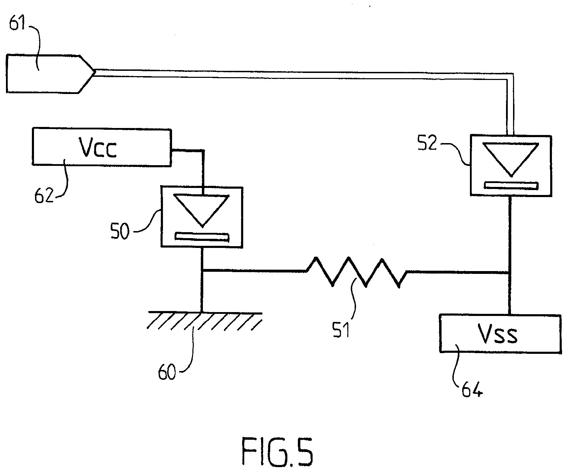

En référence à la **figure 5****,** on a représenté schématiquement le principe de polarisation du dispositif d'émission laser à modulateur de lumière intégré. Dans ce schéma, la section d'amplification laser 50 se comporte comme une diode dont l'électrode négative est reliée à la terre 60, et l'électrode positive est reliée à une tension continue 62. La tension continue 62 appliquée est par exemple +2 volts. La section de transition 51 sépare la section d'amplification 50 de la section de modulation 52. Cette section de modulation 52 est reliée par son électrode négative à un potentiel électrique de polarisation 64. Ce potentiel électrique de polarisation 64 est par exemple de -4 volts. Sur l'électrode positive de la section de modulation 52, un signal de modulation 61 est appliqué pour commander l'émission du dispositif laser.

La structure du dispositif d'émission laser décrite aux figures 1 à 5, permet de créer un canal résistif d'au moins 1 kΩ dans la section de transition 51, 11, entre la couche dopée 7 négativement de la section d'amplification et la couche dopée 7 négativement de la section de modulation.

Par exemple, pour une couche dopée 7, avec un dopage de 7 10¹⁷ cm-3, dont l'épaisseur est de 200nm, la largeur 20 est de 2 µm, la longueur 21 est de 50 µm pour un dispositif laser d'une longueur d'au moins 300 µm, la résistance par carré est de 100 ohm. La résistance inter-électrodes dans la section de transition, atteint 2,5 kΩ.

Bien que l'invention ait été décrite en liaison avec un mode de réalisation particulier, il est bien évident qu'elle n'est définie que par les revendications indépendantes.

En fonctionnement l'électrode 26 est alimentée par un générateur de signal en bande de base, non représenté, qui peut être réalisé sous différentes formes, de manière unitaire ou distribuée, au moyen de composants matériels et/ou logiciels. Des composants matériels utilisables sont les circuits intégrés spécifiques ASIC, les réseaux logiques programmables FPGA ou les microprocesseurs. Des composants logiciels peuvent être écrits dans différents langages de programmation, par exemple C, C++, Java ou VHDL. Cette liste n'est pas exhaustive.

L'usage du verbe « comporter », « comprendre » ou « inclure » et de ses formes conjuguées n'exclut pas la présence d'autres éléments ou d'autres étapes que ceux énoncés dans une revendication. L'usage de l'article indéfini « un » ou « une » pour un élément ou une étape n'exclut pas, sauf mention contraire, la présence d'une pluralité de tels éléments ou étapes.

Dans les revendications, tout signe de référence entre parenthèses ne saurait être interprété comme une limitation de la revendication.

## Revendications

1. Dispositif d'émission laser à modulateur de lumière intégré comportant :
un guide d'onde multicouche, le guide d'onde s'étendant selon une direction longitudinale du dispositif,
le guide d'onde comprenant sur une couche de support réalisée en dioxyde de silicium (3),
une première couche guidante de silicium (4),
une première couche dopée (7), dopée négativement,
une deuxième couche guidante (8) en matériau amplificateur de lumière, et
une seconde couche dopée (9, 16) de polarisation opposée à la première couche dopée,
le guide d'onde comportant le long de la direction longitudinale une section d'amplification laser (10,50),
une section de modulation de la lumière (12,52) comportant une zone d'extraction pour rayonner la lumière d'un mode optique résonnant vers l'extérieur du dispositif,
et
une section de transition (11,51) intercalée dans le sens longitudinal, entre la section d'amplification laser et la section de modulation de la lumière,
le dispositif comprenant en outre :
une première électrode positive (17) couplée à la seconde couche dopée (9, 16) dans la section d'amplification laser pour injecter un courant de pompage dans la section d'amplification laser,
une deuxième électrode positive (26) couplée à la seconde couche dopée (9,25) dans la section de modulation de lumière pour injecter un signal de modulation dans la section de modulation,
une troisième électrode négative (24) couplée à la première couche dopée (7) dans la section de modulation pour appliquer un potentiel électrique de polarisation à la première couche dopée,
et une quatrième électrode de référence (15) couplée à la première couche dopée (7) dans la section d'amplification laser,
dans lequel la seconde couche dopée (9) comprend une isolation électrique (23) située dans la section de transition du guide d'onde,
**caractérisé en ce que**
la première couche dopée (7) forme un canal résistif dans la section de transition (11, 51)entre la première couche dopée (7) de la section d'amplification (10, 50) et la première couche dopée (7) de la section de modulation (12,52).

2. Dispositif selon la revendication 1, dans lequel l'isolation électrique est obtenue par une zone d'insertion protonée (23) de la seconde couche dopée (9, 16).

3. Dispositif selon la revendication 1 ou 2, dans lequel le canal résistif présente une résistance comprise entre 1 et 10 kΩ.

4. Dispositif selon l'une des revendications 1 à 3, dans lequel la seconde couche dopée (9, 16) et la première électrode positive (17) forment une nervure étroite (40) disposée sur la deuxième couche guidante (8), la nervure étroite ayant une largeur (20) environ 5 fois inférieure à celle de la deuxième couche guidante (8) dans une partie de la section d'amplification (10).

5. Dispositif selon l'une des revendications 1 à 4, dans lequel la largeur (19) de la deuxième couche guidante (8) dans une partie de la section d'amplification et une partie de la section de modulation, appelées zones de pleine largeur, est environ 5 fois supérieure à la largeur appelée zone étroite de ladite deuxième couche guidante dans la section de transition.

6. Dispositif selon la revendication 5, dans lequel la largeur de la deuxième couche guidante (8) se réduit progressivement depuis la largeur de chaque zone de pleine largeur vers la largeur de la zone étroite.

7. Dispositif selon l'une des revendications 1 à 6, dans lequel un profil en largeur de la première couche guidante (4) est identique à un profil en largeur de la deuxième couche guidante (8).

8. Dispositif selon l'une des revendications 1 à 7, dans lequel la première couche guidante (4), la première couche dopée (7), la deuxième couche guidante (8), la seconde couche dopée (9, 16) et la première électrode positive (17) forment une nervure étroite (40) dans la section de transition (11).

9. Dispositif selon l'une des revendications 1 à 8, dans lequel le canal résistif présente une largeur inférieure à 3 µm.

10. Dispositif selon l'une des revendications 1 à 9, dans lequel la zone de transition présente une longueur sensiblement égale à 50 µm.

11. Dispositif selon l'une des revendications 1 à 10, dans lequel la seconde couche dopée (9) et la troisième couche dopée sont sélectionnées dans des matériaux du groupe III-V des semi-conducteurs.

12. Dispositif selon l'une des revendications 1 à 11, dans lequel la seconde couche dopée (9) présente une épaisseur inférieure à 250 nm.

13. Dispositif selon l'une des revendications 1 à 12, dans lequel la première électrode positive (17) et la seconde couche dopée (9) de ladite section d'amplification (10) sont séparées par une couche (16) d'un alliage d'arséniure de gallium-indium dopée positivement.

14. Dispositif selon l'une des revendications 1 à 13, dans lequel la deuxième électrode positive (26) et la seconde couche dopée (9) de ladite section de modulation (12) sont séparées par une couche d'un alliage d'arséniure de gallium-indium dopée positivement.

15. Utilisation d'un dispositif selon l'une des revendications 1 à 14, dans lequel la troisième électrode négative (24) est connectée à un potentiel continu négatif (64), la première électrode positive (17) est connectée à un potentiel continu positif (62), l'électrode de référence (15) est connectée à un potentiel électrique de terre (60), et la deuxième électrode positive (26) est connectée à un générateur de signal en bande de base.

## Patentansprüche

1. Laseremissionsvorrichtung mit integriertem Lichtmodulator, die aufweist:
einen Mehrschicht-Wellenleiter, wobei sich der Wellenleiter gemäß einer Längsrichtung der Vorrichtung erstreckt,
wobei der Wellenleiter auf einer aus Siliziumdioxid hergestellten Trägerschicht (3) umfasst,
eine erste leitende Siliziumschicht (4),
eine erste dotierte Schicht (7), die negativ dotiert ist,
eine zweite leitende Schicht (8) aus lichtverstärkendem Material, und
eine zweite dotierte Schicht (9, 16) mit zu der ersten dotierten Schicht entgegengesetzten Polarisierung,
wobei der Wellenleiter entlang der Längsrichtung aufweist einen Laserverstärkungsabschnitt (10, 50),
einen Lichtmodulationsabschnitt (12, 52), der eine Extraktionszone aufweist, um das Licht eines optischen Resonanzmodus nach außerhalb der Vorrichtung zu strahlen, und
einen Übergangsabschnitt (11, 51), der in Längsrichtung zwischen dem Laserverstärkungsabschnitt und dem Lichtmodulationsabschnitt angeordnet ist,
wobei die Vorrichtung ferner umfasst:
eine erste positive Elektrode (17), die an die zweite dotierte Schicht (9, 16) im Laserverstärkungsabschnitt gekoppelt ist, um einen Pumpstrom in den Laserverstärkungsabschnitt einzuleiten,
eine zweite positive Elektrode (26), die an die zweite dotierte Schicht (9, 25) im Lichtmodulationsabschnitt gekoppelt ist, um ein Modulationssignal in den Modulationsabschnitt einzuleiten,
eine dritte negative Elektrode (24), die an die erste dotierte Schicht (7) im Modulationsabschnitt gekoppelt ist, um ein elektrisches Polarisationspotential auf die erste dotierte Schicht anzuwenden,
und eine vierte Referenzelektrode (15), die an die erste dotierte Schicht (7) im Laserverstärkungsabschnitt gekoppelt ist,
wobei die zweite dotierte Schicht (9) eine elektrische Isolierung (23) umfasst, die sich im Übergangsabschnitt des Wellenleiters befindet
**dadurch gekennzeichnet, dass** die erste dotierte Schicht (7) einen resistiven Kanal im Übergangsabschnitt (11, 51) zwischen der ersten dotierten Schicht (7) des Verstärkungsabschnitts (10, 50) und der ersten dotierten Schicht (7) des Modulationsabschnitts (12, 52) bildet.

2. Vorrichtung nach Anspruch 1, wobei die elektrische Isolierung durch eine protonierte Insertionszone (23) der zweiten dotierten Schicht (9, 16) erhalten wird.

3. Vorrichtung nach Anspruch 1 oder 2, wobei der resistive Kanal einen Widerstand zwischen 1 und 10 kQ aufweist.

4. Vorrichtung nach einem der Ansprüche 1 bis 3, wobei die zweite dotierte Schicht (9, 16) und die erste positive Elektrode (17) eine schmale Rippe (40) bilden, die auf der zweiten leitenden Schicht (8) angeordnet ist, wobei die schmale Rippe eine Breite (20) hat, die zirka 5 Mal kleiner als die der zweiten leitenden Schicht (8) in einem Teil des Verstärkungsabschnitts (10) ist.

5. Vorrichtung nach einem der Ansprüche 1 bis 4, wobei die Breite (19) der zweiten leitenden Schicht (8) in einem Teil des Verstärkungsabschnitts und einem Teil des Modulationsabschnitts, bezeichnet als Zonen voller Breite, zirka 5 Mal größer als die Breite, die als schmale Zone bezeichnet wird, der zweiten leitenden Schicht im Übergangsabschnitt ist.

6. Vorrichtung nach Anspruch 5, wobei sich die Breite der zweiten leitenden Schicht (8) ab der Breite jeder Zone voller Breite zur Breite der schmalen Zone schrittweise reduziert.

7. Vorrichtung nach einem der Ansprüche 1 bis 6, wobei ein Breitenprofil der ersten leitenden Schicht (4) mit einem Breitenprofil der zweiten leitenden Schicht (8) identisch ist.

8. Vorrichtung nach einem der Ansprüche 1 bis 7, wobei die erste leitende Schicht (4), die erste dotierte Schicht (7), die zweite leitende Schicht (8), die zweite dotierte Schicht (9, 16) und die erste positive Elektrode (17) schmale Rippe (40) im Übergangsabschnitt (11) bilden.

9. Vorrichtung nach einem der Ansprüche 1 bis 8, wobei der resistive Kanal eine Breite von weniger als 3 µm aufweist.

10. Vorrichtung nach einem der Ansprüche 1 bis 9, wobei die Übergangszone eine Länge von etwa gleich 50 µm aufweist.

11. Vorrichtung nach einem der Ansprüche 1 bis 10, wobei die zweite dotierte Schicht (9) und die dritte dotierte Schicht aus Materialien der Gruppe III-V der Halbleiter ausgewählt sind.

12. Vorrichtung nach einem der Ansprüche 1 bis 11, wobei die zweite dotierte Schicht (9) eine Dicke von weniger als 250 nm aufweist.

13. Vorrichtung nach einem der Ansprüche 1 bis 12, wobei die erste positive Elektrode (17) und die zweite dotierte Schicht (9) des Verstärkungsabschnitts (10) durch eine Schicht (16) aus einer positiv dotierten Gallium-Indium-Arsenid-Legierung getrennt sind.

14. Vorrichtung nach einem der Ansprüche 1 bis 13, wobei die zweite positive Elektrode (26) und die zweite dotierte Schicht (9) des Modulationsabschnitts (12) durch eine Schicht aus einer positiv dotierten Gallium-Indium-Arsenid-Legierung getrennt sind.

15. Verwendung einer Vorrichtung nach einem der Ansprüche 1 bis 14, wobei die dritte negative Elektrode (24) mit einem negativen Gleichstrompotential (64) verbunden ist, die erste positive Elektrode (17) mit einem positiven Gleichstrompotential (62) verbunden ist, die Referenzelektrode (15) mit einem elektrischen Erdungspotential (60) verbunden ist und die zweite positive Elektrode (26) mit einem Basisband-Signalerzeuger verbunden ist.

## Claims

1. Laser emission device with integrated light modulator comprising:
a multilayer waveguide, the waveguide extending along a longitudinal direction of the device,
the waveguide comprising, on a support layer made of silicon dioxide (3),
a first guiding layer of silicon (4),
a negatively doped first doped layer (7),
a second guiding layer (8) of light amplifying material, and
a biasing second doped layer (9, 16) opposite the first doped layer,
the waveguide comprising, along the longitudinal direction
a laser amplification section (10, 50),
a light modulation section (12, 52) comprising an extraction zone for radiating the light of a resonant optical mode towards the exterior of the device, and
a transition section (11, 51) inserted in the longitudinal direction, between the laser amplification section and the light modulation section,
the device also comprising:
a positive first electrode (17) coupled the second doped layer (9, 16) in the laser amplification section to inject a pumping current into the laser amplification section,
a positive second electrode (26) coupled to the second doped layer (9, 25) in the light modulation section to inject a modulation signal into the modulation section,
a negative third electrode (24) coupled to the first doped layer (7) in the modulation section to apply a biasing electrical potential to the first doped layer, and
a reference fourth electrode (15) coupled to the first doped layer (7) in the laser amplification section,
wherein the second doped layer (9) comprises an electrical insulation (23) situated in the transition section of the waveguide,
**characterized in that**
the first doped layer (7) forms a resistive channel in the transition section (11, 51) between the first doped layer (7) of the amplification section (10, 50) and the first doped layer (7) of the modulation section (12, 52).

2. Device according to claim 1, wherein the electrical insulation is obtained by a protonated insertion zone (23) of the second doped layer (9, 16).

3. Device according to claim 1 or 2, wherein the resistive channel exhibits a resistance of between 1 and 10 kQ.

4. Device according to any of claims 1 to 3, wherein the second doped layer (9, 16) and the positive first electrode (17) form a narrow ridge (40) positioned on the second guiding layer (8), the straight ridge having a width (20) approximately 5 times less than that of the second guiding layer (8) in a part of the amplification section (10).

5. Device according to any of claims 1 to 4, wherein the width (19) of the second guiding layer (8) in a part of the amplification section and a part of the modulation section, called full width zones, is approximately 5 times greater than the width, called narrow zone, of said second guiding layer in the transition section.

6. Device according to claim 5, wherein the width of the second guiding layer (8) is progressively reduced from the width of each full width zone to the width of the narrow zone.

7. Device according to any of claims 1 to 6, wherein a width wise profile of the first guiding layer (4) is identical to a width wise profile of the second guiding layer (8).

8. Device according to any of claims 1 to 7, wherein the first guiding layer (4), the first doped layer (7), the second guiding layer (8), the second doped layer (9, 16) and the positive first electrode (17) form a narrow ridge (40) in the transition section (11).

9. Device according to any of claims 1 to 8, wherein the resistive channel has a width less than 3 µm.

10. Device according to any of claims 1 to 9, wherein the transition zone has a length substantially equal to 50 µm.

11. Device according to any of claims 1 to 10, wherein the second doped layer (9) and the third doped layer are selected from materials from the group III-V of semiconductors.

12. Device according to any of claims 1 to 11, wherein the second doped layer (9) has a thickness less than 250 nm.

13. Device according to any of claims 1 to 12, wherein the positive first electrode (17) and the second doped layer (9) of said amplification section (10) are separated by a layer (16) of a positively doped gallium indium arsenide alloy.

14. Device according to any of claims 1 to 13, wherein the positive second electrode (26) and the second doped layer (9) of said modulation section (12) are separated by a layer of a positively doped gallium indium arsenide alloy.

15. Use of a device according to any of claims 1 to 14, wherein the negative third electrode (24) is connected to a negative DC potential (64), the positive first electrode (17) is connected to a positive DC potential (62), the reference electrode (15) is connected to an earth electrical potential (60), and the positive second electrode (26) is connected to a base band signal generator.
